# EUROPEAN PATENT APPLICATION

(11) **EP 3 748 859 A1**
(43) Date of publication of application: **09.12.2020**
(21) Application number: 20175512.1
(22) Date of filing: 19.05.2020
(51) Int. Cl.: H03M 1/66

(54) **DAC DEVICE HAVING POSITIVE DAC AND NEGATIVE DAC AND ASSOCIATED DIGITAL-TO-ANALOG CONVERTING METHOD**

(30) Priority: 06.06.2019 US 201962857934 P; 15.05.2020 US 202016874702
(71) Applicant: MEDIATEK INC., Hsin-Chu 300 (TW)
(72) Inventor: TSENG, Wei-Hsin, Hsin-Chu 30078 (TW); LIN, Wei-Te, Hsinchu City 30078 (TW); HUANG, Chang-Yang, Hsin-Chu 30078 (TW); CHEN, Hsin-Wei, Hsin-Chu 30078 (TW); HSU, Chung-Wei, Hsin-Chu 30078 (TW)
(74) Representative: Haseltine Lake Kempner LLP

(57) **Abstract**

The present invention discloses a DAC device including a positive DAC, a negative DAC and an output circuit. The positive DAC is configured to perform a digital-to-analog converting operation on a digital input signal based on a first pulse signal to generate a first analog signal, wherein the first analog signal comprises a convolution result of the first pulse signal and the digital input signal. The negative DAC is configured to perform the digital-to-analog converting operation on the digital input signal based on a second pulse signal to generate a second analog signal, wherein the second analog signal comprises a convolution result of the second pulse signal and the digital input signal. The output circuit is configured to generate an output analog signal according to the first analog signal and the second analog signal.

## Description

This application claims the priority of US Provisional Application No. 62/857,934, filed on June 6th, 2019.

### Background

In order to synthesize output signal at 2^{nd} Nyquist zone, a mixing Digital to Analog Converter (DAC) is provided to make an analog output signal be toggled between a positive value and a negative value. However, as data needed to be processed by the DAC becomes faster, design of mixing DAC will be more difficult.

### Summary

It is therefore an objective of the present invention to provide a DAC device, to solve the above-mentioned problems.

According to one embodiment of the present invention, a DAC device comprising a positive DAC, a negative DAC and an output circuit is disclosed. The positive DAC is configured to perform a digital-to-analog converting operation on a digital input signal based on a first pulse signal to generate a first analog signal, wherein the first analog signal is a convolution result of the first pulse signal and the digital input signal. The negative DAC is configured to perform the digital-to-analog converting operation on the digital input signal based on a second pulse signal to generate a second analog signal, wherein the second analog signal is a convolution result of the second pulse signal and the digital input signal. The output circuit is configured to generate an output analog signal according to the first analog signal and the second analog signal.

According to another embodiment of the present invention, a DAC device comprising a first DAC, a delay and multiplier circuit, a second DAC and an output circuit is disclosed. The first DAC is configured to perform a digital-to-analog converting operation on a digital input signal to generate a first analog signal. The delay and multiplier circuit is configured to delay and multiply the digital input signal by a dedicated number. An embodiment of the present invention, this number is -1. It generates a delayed and complementary digital signal. The second DAC is configured to perform the digital-to-analog converting operation on the delayed and complementary digital signal to generate the second analog signal. The output circuit is configured to combines half of the first analog signal and half of the second analog signal to generate an output analog signal.

According to another embodiment of the present invention, digital-to-analog converting method comprises the steps of: performing a digital-to-analog converting operation on a digital input signal based on a first pulse signal to generate a first analog signal, wherein the first pulse signal comprises a positive value; performing the digital-to-analog converting operation on the digital input signal based on a second pulse signal to generate a first analog signal, wherein the second pulse signal comprises a negative value; and generating an output analog signal according to the first analog signal and the second analog signal.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a DAC device according to one embodiment of the present invention.
FIG. 2 shows the detailed operations of the DAC device shown in FIG. 1.
FIG. 3 is a diagram illustrating a DAC device according to one embodiment of the present invention.
FIG. 4 is a flowchart of a digital-to-analog converting method according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

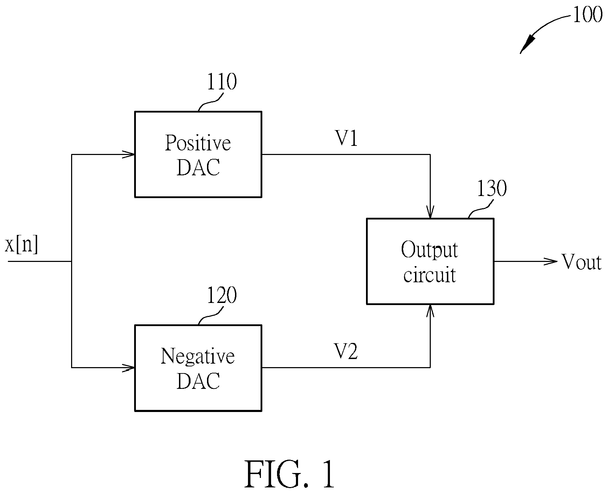

FIG. 1 is a diagram illustrating a DAC device 100 according to one embodiment of the present invention. As shown in FIG. 1, the DAC device 100 comprises a positive DAC 110, a negative DAC 120 and an output circuit 130. In the operations of the DAC device 100, the positive DAC 110 performs a digital-to-analog converting operation on a digital input signal x[n] to generate a first analog signal V1, the negative DAC 120 performs a digital-to-analog converting operation on the digital input signal x[n] to generate a second analog signal V2, and the output circuit 130 generates an output analog signal Vout according to the first analog signal V1 and the second analog signal V2.

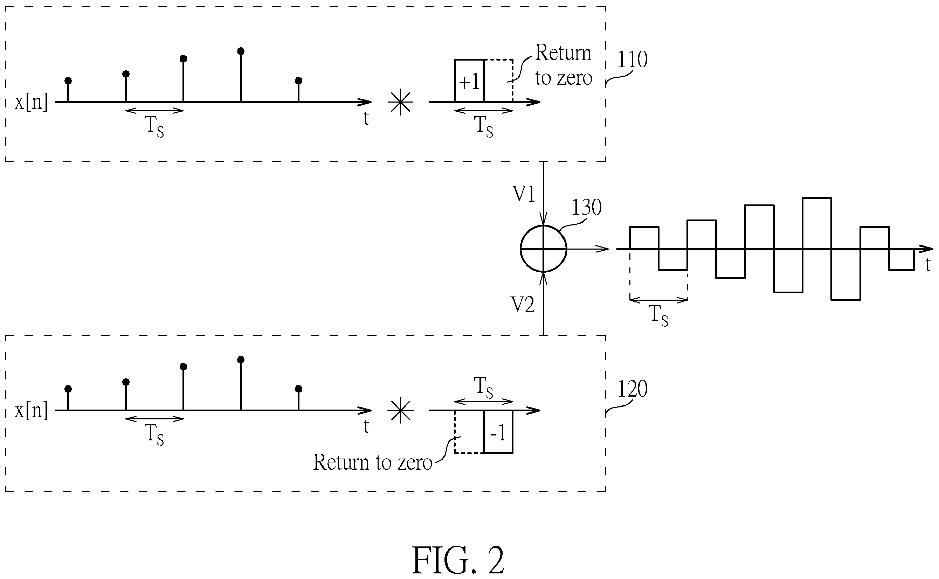

Specifically, referring to FIG. 2, the digital input signal x[n] has a period Ts, and the positive DAC 110 performs the digital-to-analog converting operation on the digital input signal x[n] based on a first pulse signal, wherein a period of the first pulse signal is equal to the period Ts of the digital input signal x[n], a first half of the first pulse signal is the positive value (e.g. '+1' shown in FIG. 2, positive step function), and a second half of the first pulse signal is zero. In addition, the negative DAC 120 performs the digital-to-analog converting operation on the digital input signal x[n] based on a second pulse signal, wherein a period of the second pulse signal is equal to the period Ts of the digital input signal x[n], a first half of the second pulse signal is zero, and a second half of the second pulse signal is a negative value (e.g. '-1' shown in FIG. 2, negative step function). In this embodiment, the first analog signal V1 generated by the positive DAC 110 can be regarded as a convolution calculation result of the digital input signal x[n] and the first pulse signal, and the second analog signal V2 generated by the negative DAC 120 can be regarded as a convolution calculation result of the digital input signal x[n] and the second pulse signal. In addition, the output circuit 130 may combine a first half of period the first analog signal V1 and a second half of the period of the second analog signal V2 to generate the output analog signal Vout, wherein positive portion of the output analog signal Vout is provided by the first analog signal V1, and negative portion of the output analog signal Vout is provided by the second analog signal V2.

In the embodiment shown in FIG. 1 and FIG. 2, because the DAC device 100 generates the output analog signal Vout toggled between the positive value and the negative value, the notch frequency point of the holding shape will be changed to favorite 2^{nd} Nyquist zone, and the output analog signal Vout is more appropriate for the following signal processing steps. In addition, by using the positive DAC 110 using the first pulse signal whose first half of period is a positive value and second half of period is zero, and using the negative DAC 120 using the second pulse signal whose first half of period is zero and second half of period is a negative value, the positive DAC 110 and the negative DAC 120 have more settling time to provide stable first analog signal V1 and second analog signal V2, respectively. Therefore, the DAC device 100 is suitable for the high speed applications.

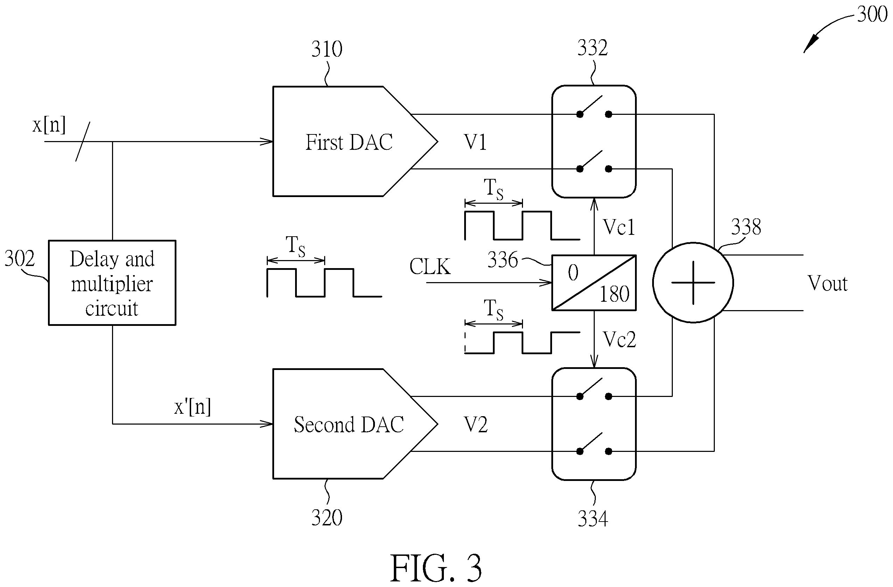

FIG. 3 is a diagram illustrating a DAC device 300 according to one embodiment of the present invention. A shown in FIG. 3, the DAC device 300 comprises a delay and multiplier circuit 302, a first DAC 310, a second DAC 320, a first switch 332, a second switch 334, a control signal generator 336 and a combiner 338. In this embodiment, the first DAC 310 corresponds to the positive DAC 110 shown in FIG. 1, the delay and multiplier circuit 302 and the second DAC 320 corresponds to the negative DAC 120, and the first switch 332, the second switch 334, the control signal generator 336 and the combiner 338 can correspond to the output circuit 130.

In the operations of the DAC device 300, the first DAC 310 performs the digital-to-analog converting operation on the digital input signal x[n] based on a pulse signal (e.g. the first pulse signal shown in FIG. 2), to generate the first analog signal V1. The delay and multiplier circuit 302 delays the digital input signal x[n] and complementary of digital input signal x[n] (e.g. multiply the digital input signal x[n] by "-1", and positive value becomes negative value, or negative value becomes positive value) to generate digital signal x'[n], wherein delay amount of the delay and multiplier circuit 302 is half of a period of the digital input signal (i.e. delay amount is equal to (Ts/2)). Then, the second DAC 320 performs the digital-to-analog converting operation on the digital signal x'[n] based on a pulse signal, to generate the second analog signal V2. In this embodiment, the first DAC 310 and the second DAC may have the same circuit structure.

The control signal generator 336 is configured to generate a first control signal Vc1 and a second control signal Vc2 to control the first switch 332 and the second switch 334, respectively. In one embodiment, the control signal generator 336 may generate the first control signal Vc1 and the second control signal Vc2 based on a clock signal CLK, the first control signal Vc1 may be equal to the clock signal CLK, and the second control signal Vc2 can be another clock signal generated by delaying the clock signal CLK with 180 degree, that is a phase difference between the first control signal Vc1 and the second control signal Vc2 is 180 degree. Then, the first switch 332 is controlled by the first control signal Vc1 to output the half period of the first analog signal V1 to the combiner 338, the second switch 334 is controlled by the first control signal Vc2 to output the half period of the second analog signal V2 to the combiner 338, and the combiner 338 combines the half period of the first analog signal V1 and the half period of the second analog signal V2 to generate the output analog signal Vout.

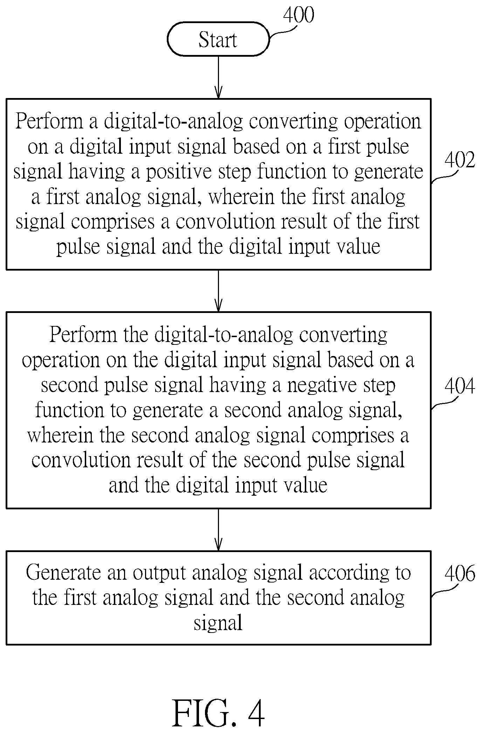

FIG. 4 is a flowchart of a digital-to-analog converting method according to one embodiment of the present invention. Referring to FIGs. 1-4 and above embodiments, the flow is described as follows.

Step 400: the flow starts.

Step 402: perform a digital-to-analog converting operation on a digital input signal based on a first pulse signal having a positive step function to generate a first analog signal, wherein the first analog signal comprises a convolution result of the first pulse signal and the digital input value.

Step 404: perform the digital-to-analog converting operation on the digital input signal based on a second pulse signal having a negative step function to generate a second analog signal, wherein the second analog signal comprises a convolution result of the second pulse signal and the digital input value.

Step 406: generate an output analog signal according to the first analog signal and the second analog signal.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A digital-to-analog converter, DAC, device (100), comprising:
a positive DAC (110), configured to perform a digital-to-analog converting operation on a digital input signal based on a first pulse signal having a positive step function to generate a first analog signal, wherein the first analog signal comprises a convolution result of the first pulse signal and the digital input value;
a negative DAC (120), configured to perform the digital-to-analog converting operation on the digital input signal based on a second pulse signal having a negative step function to generate a second analog signal, wherein the second analog signal comprises a convolution result of the second pulse signal and the digital input value; and
an output circuit (130), coupled to the positive DAC (110) and the negative DAC (120), configured to generate an output analog signal according to the first analog signal and the second analog signal.

2. The DAC device (100) of claim 1, wherein the a period of the first pulse signal is equal to a period of the digital input signal, a first half of the period of the first pulse signal is the positive value, and a second half of the period of the first pulse signal is zero.

3. The DAC device (100) of claim 2, wherein a period of the second pulse signal is equal to the period of the digital input signal, a first half of the period of the second pulse signal is zero, and a second half of the period of the second pulse signal is a negative value.

4. The DAC device (100) of claim 3, wherein the output circuit (130) combines the first half of the period of the first analog signal and the second half of the period of the second analog signal to generate the output analog signal.

5. The DAC device (100) of claim 1, wherein the negative DAC (120) comprises:
a delay and multiplier circuit, configured to generate a delayed and complementary digital signal based on the input digital signal;
wherein the delayed and complementary digital signal is converted to generate the second analog signal.

6. The DAC device (100) of claim 5, wherein delay amount of the delay and multiplier circuit is half of a period of the digital input signal.

7. A digital-to-analog converter, DAC, device (300), comprising:
a first DAC (310), configured to perform a digital-to-analog converting operation on a digital input signal to generate a first analog signal;
a delay and multiplier circuit (302), configured to delay and multiply the digital input signal by "-1" to generate a delayed and complementary digital signal;
a second DAC (320), configured to perform the digital-to-analog converting operation on the delayed and complementary digital signal to generate a second analog signal; and
an output circuit, coupled to the first DAC (310) and the second DAC (320), configured to combines half of the first analog signal and half of the second analog signal to generate an output analog signal.

8. The DAC device (300) of claim 7, wherein delay amount of the delay and multiplier circuit (302) is half of a period of the digital input signal.

9. The DAC device (300) of claim 7, wherein the output circuit comprises:
a first switch, coupled to the first DAC (310), configured to receive the first analog signal and output the half of the first analog signal;
a second switch, coupled to the second DAC (320), configured to receive the second analog signal and output the half of the second analog signal; and
a combiner, configured to combine the half of the first analog signal and the half of the second analog signal to generate the output analog signal.

10. The DAC device (300) of claim 9, wherein the first switch is controlled by a first clock signal whose period is equal to a period of the digital input signal, the second switch is controlled by a second clock signal whose period is equal to the period of the digital input signal, and a phase difference between the first clock signal and the second clock signal is 180 degree.

11. A digital-to-analog converting method, comprising:
performing (402) a digital-to-analog converting operation on a digital input signal based on a first pulse signal to generate a first analog signal having a positive step function, wherein the first analog signal comprises a convolution result of the first pulse signal and the digital input signal;
performing (404) the digital-to-analog converting operation on the digital input signal based on a second pulse signal having a negative pulse function to generate a second analog signal, wherein the second analog signal comprises a convolution result of the second pulse signal and the digital input signal; and
generating (406) an output analog signal according to the first analog signal and the second analog signal.

12. The digital-to-analog converting method of claim 11, wherein a period of the first pulse signal is equal to a period of the digital input signal, a first half of the period of the first pulse signal is a positive step function, and a second half of the period of the first pulse signal is zero.

13. The digital-to-analog converting method of claim 12, wherein a period of the second pulse signal is equal to the period of the digital input signal, a first half of the period of the second pulse signal is zero, and a second half of the period of the second pulse signal is a negative step function.

14. The digital-to-analog converting method of claim 13, wherein the step of generating an output analog signal according to the first analog signal and the second analog signal comprises:
combining the first half of the period of the first analog signal and the second half of the period of the second analog signal to generate the output analog signal.
